# EUROPEAN PATENT APPLICATION

(11) **EP 1 420 082 A1**
(43) Date of publication of application: **19.05.2004**
(21) Application number: 02749355.0
(22) Date of filing: 24.07.2002
(51) Int. Cl.: C23C 30/00, C25D 5/34, C25D 5/54

(54) **ELECTROCONDUCTIVE STRUCTURE AND ELECTROPLATING METHOD USING THE STRUCTURE**

(30) Priority: 24.07.2001 JP 2001222459
(71) Applicant: Creatic Japan, Inc., Fukui City, Fukui 910-0001 (JP)
(72) Inventor: MATSUSHITA, Atsushi, c/o CREATIC JAPAN, INC., Fukui City, Fukui 910-0001 (JP)
(74) Representative: Modiano, Micaela
(86) International application number: PCT/JP2002/007493
(87) International publication number: WO 2003/010357

(57) **Abstract**

A structure that is endowed with electric conductivity by plate-coating with a titanium nitride layer or by generation of a titanium nitride layer on a surface of a base material made of an inorganic material or an organic material, and a method of electroplating a cathode with a simple metal or an alloy, wherein the structure is used as an anode and/or a cathode. The structure is corrosion-resistant and has high electroconductivity, and thus the electroplating method using the structure allows the simplification and the cost reduction of an electroplating process.

## Description

### Technical Field

The present invention relates to a structure having on its base material surface a specific compound layer and having electric conductivity, and to an electroplating method using the structure.

### Background Art

Since platinum is superior in corrosion resistance, platinum is widely used for electrodes, plating, ornaments and others. At present, however, platinum is more expensive than other metals such as gold. Thus, it has been desired to supply electrodes, plating, ornaments and others using other relatively inexpensive metals.

Japanese Patent Application Laid-Open Gazette (JP-A) No. 7-18469 (laid-open date: January 20, 1995) discloses a golden plated ornament having, as its topmost surface, a gold alloy coated layer. Japanese Patent Application Publication Gazette (JP-B) No. 6-39684 (publication date: May 25, 1994) also discloses an ornament plated with a simple metal such as gold, or an alloy.

However, both plating treatments with gold, which are used in these prior techniques, are dry plating treatments and are not electroplating treatments using electrolysis.

In plating process of titanium with gold, it is necessary to use two-stages process in which titanium is plated with nickel and then plated with gold. Thus, it has been desired to make the process simpler.

An object of the present invention is to provide a structure that is inexpensive and has corrosion resistance and electric conductivity, and provide an inexpensive electroplating method the process of which is simple.

### Disclosure of Invention

The present inventor has paid attention to the matter that titanium nitride (TiN) is a good conductor for electricity, and has found out that a structure having a titanium nitride layer has good electric conductivity and this structure is used to carry out an electroplating method, whereby an electroplated product can be inexpensively obtained through a simple process. Thus, the present invention has been made.

That is, the present invention relates to a structure that is endowed with electric conductivity by plate-coating with a titanium nitride layer or by generation of a titanium nitride layer on a surface of a base material made of an inorganic material.

The present invention also relates to a structure that is endowed with electric conductivity by plate-coating with a titanium nitride layer or by generation of a titanium nitride layer on a surface of a base material made of an organic material.

The base material may be made of a metal having electric conductivity. In particular, the base material may be made of titanium or a titanium alloy. In this case, the base material surface is subjected to direct nitriding, whereby a structure endowed with electric conductivity can be obtained. The base material may be made of a material having no electric conductivity.

The thickness of the titanium nitride layer may be from 0.01 to 3 µm.

The present invention relates to a method of electroplating a cathode with a simple metal or an alloy, wherein an anode comprises a structure that is endowed with electric conductivity by plate-coating with a titanium nitride layer or by generation of a titanium nitride layer on a surface of a base material made of an inorganic material or an organic material.

Furthermore, the present invention relates to a method of electroplating a cathode with a simple metal or an alloy, wherein the cathode comprises a structure that is endowed with electric conductivity by plate-coating with a titanium nitride layer or by generation of a titanium nitride layer on a surface of a base material made of an inorganic material or an organic material.

In the above-mentioned methods, the cathode can be plated with a noble metal.

### Best Mode for Carrying Out the Invention

The ingredient of the base material is not particularly limited if the ingredient makes it possible to form, on a surface thereof, a titanium nitride layer. Examples of the ingredients are not only titanium itself but also titanium alloys, tungsten, iron, organic materials which can resist a high temperature of about 200°C (for example, an aramid resin and a polyester resin), glass, steel, copper, brass, aluminum, zinc, magnesium, aluminum alloys, zinc alloys, magnesium alloys, lead-silver alloys, high-silicon cast iron, magnetic iron oxide, ferrite, artificial graphite, carbon fibers, silicon carbide fibers, and boron fibers. The form of the base material may include any form, and, for example, a flat plate, a mesh, a foil, a sphere, a cube, a cylinder, a cone, a weaving and a nonwoven.

In a case where the ingredient of the base material is titanium, a structure having on a surface of the base material a titanium nitride layer, can be obtained, for example, by evacuating a vacuum heating furnace, filling nitrogen gas into the furnace, heating the titanium base material up to 800 to 1200°C, preferably 900 to 1100°C in an atmosphere of nitrogen gas at a pressure of 1 × 10³ to 1 × 10⁵ Pa, preferably 1 × 10⁴ to 1 × 10⁵ Pa, keeping this temperature for 1 to 60 minutes, preferably 30 to 60 minutes, and subsequently naturally-cooling the resultant in an atmosphere of nitrogen gas in such a manner that the temperature of the base material will be lowered to a temperature of 100 to 300°C.

In a case where the ingredient of the base material is other than titanium, any method can be adopted if the method is a method making it possible to yield a structure having on its base material surface a titanium nitride layer. For example, an ion plating method wherein vacuum evaporation is combined with sputtering can be used. For example, conditions for using the ion plating method are as follows; a substrate is used as the base material, and argon (Ar) gas is introduced into an ion plating device, then the device is degassed to have a vacuum of 10⁻⁵ to 10⁻³ Torr, and Ar gas sputtering is performed at a substrate applied voltage of 350 to 500 V for 15 to 40 minutes, titanium metal is then evaporated by means of a thermionic gun, then plasma is generated near electrodes at an ionization voltage of 30 to 50 V and an ionization current of 40 to 60 A so as to ionize the evaporated titanium molecules, and a negative voltage is applied to the substrate to form a Ti coat, nitrogen gas is then introduced thereto at an ionization voltage of 45 to 70 V and an ionization current of 55 to 75 A. In this way, a structure having on its base material surface a titanium nitride layer, may be obtained.

Such an ion plating method may not make it possible that a large-sized base material is plated because the container to be evacuated is limited. Repeatability of conditions is also difficult to perform, so uneven plating and uneven coloration may be generated.

In a case where the titanium nitride layer is a membrane covering the base material, the membrane thickness thereof can be 0.01 to 3 µm, preferably 0.05 to 2 µm, and more preferably 0.1 to 1.0 µm.

An example of the simple metal which can be used in the electroplating method is platinum, palladium, gold, silver, copper, zinc, indium, germanium, cobalt, zirconium, tungsten, tantalum, niobium, manganese, molybdenum, tin, iron, aluminum or cadmium. Among these simple metals, platinum, palladium, gold and cobalt are preferable because of expensiveness thereof. The simple metal layer formed by electroplating treatment is usually a membrane, and the membrane thickness thereof can be set according to the use of the plated product. For example, where a plated product is to be used for a semiconductor, the product comprises a plated gold membrane having a thickness of 5 µm or more, and where a plated product is to be used for an ornament, the product generally comprises a plated gold membrane having a thickness of 1 to 3 µm.

An example of the alloy used in the electroplating method is a platinum alloy, a palladium alloy, a gold alloy, a silver alloy, a copper alloy, a zinc alloy, an indium alloy, a germanium alloy, a cobalt alloy, a zirconium alloy, a tungsten alloy, a tantalum alloy, a niobium alloy, a manganese alloy, a molybdenum alloy, a tin alloy, an iron alloy, an aluminum alloy, a cadmium alloy, or a blend alloy thereof. Specific examples thereof are Au-Co alloy, Ni-Co alloy, Cu-Zn alloy, Cu-Sn alloy, Au-Cu alloy, Pb-Sn alloy, Sn-Zn alloy, Sn-Cd alloy, Ag-Pb alloy, In-Sn alloy, W-Fe alloy, and W-Co alloy or the like.

Alloy plating is performed in order to improve the functionality of an object, or to endow an object with functionality. For example, in a case where Ni-Co alloy is applied by plating, results of the plating differ if energization conditions differ. If a well-known Weissberg bath is used, an increase in current density causes a Co content in an electrodeposit to get smaller. In the present invention, as an example, a structure having on its base material surface a titanium nitride layer, was plated with gold-cobalt.

The plating bath used in the electroplating method of the present invention is not particularly limited if the plating bath is a plating bath making it possible to apply the above-mentioned metal to the titanium nitride layer by electroplating. Examples of said plating baths are a sulfuric acid bath, a borofluoride bath, a pyrophosphoric acid bath, a zincate bath, an amine bath, a chloride bath, a cyanide bath, a Watt bath, a sulfamic acid bath, an ordinary bath, a Weissberg bath, a sodium bath, a potassium bath, a strike bath and the like. Among these plating baths, acidic baths such as a sulfuric acid bath are preferable because the structure of the present invention can be used therein as an anode instead of a platinum electrode. A neutral bath or an alkali bath may also be sufficient for the structure of the present invention to be used therein as an anode. Usually, in alkali baths, stainless steel is used as an anode in many cases, and platinum, which is expensive, is not used very much.

In the method of the present invention, a structure having on its base material surface a titanium nitride layer, is used as an electrode; therefore, this electrode can be used as an anode instead of a platinum electrode and thus the method is inexpensive. Electroplating treatment can be applied directly to the titanium nitride layer, so it is unnecessary to use nickel and to worry about nickel allergy. Even if pretreatment for cleaning the base material surface, such as acid cleaning or degreasing, is not conducted, gold or the like can be stably and firmly attached to the base material surface by the electroplating treatment because the titanium nitride layer has been formed.

The structure of the present invention can be applied to any product if the product is to be energized. The structure of the present invention can be used, for example, in the following products: energization parts such as a plug pin of electric heating articles; various electrodes such as plating electrodes, inner wall electrodes of an electrolysis cell, electrodes for electrolytic protection, reference electrodes, and electrodes for regenerating deteriorated concrete (an alkalifying method, a desalting method and so on), and a conductor.

According to the present invention, an electroplated product obtained by electroplating a structure having on its base material surface a titanium nitride layer with a metal such as gold, can be used, for example, in the following products: personal ornaments such as a watch case, a watch band, the frame of a pair of spectacles, and a pendant; energization parts such as a plug pin of electric heating articles; various electrodes such as plating electrodes, inner wall electrodes of an electrolysis cell, electrodes for electrolytic protection, reference electrodes and electrodes for regenerating deteriorated concrete (an alkalifying method, a desalting method and so on); machining tools such as a mold; metal dedicated materials for building or construction such as a shutter, a guardrail and a window frame; and packaging metal containers such as high-pressure gas cylinder and a drum; a dental prosthesis; tableware such as a teapot and a rice bowl; an electrolysis cell; an industrial water tank; a semiconductor device; and a conductor.

### Example 1

A vacuum heating furnace was evacuated, and subsequently nitrogen gas was introduced into the furnace to heat a titanium plate (20 cm in length, 4.5 cm in width, and 1.1 mm in thickness) therein up to 1000°C at a pressure of 5 × 10⁴ Pa. This temperature was kept for 30 minutes. Thereafter, the titanium plate was naturally cooled to a temperature of 200°C in an atmosphere of the nitrogen gas so as to yield a plate having a titanium nitride layer (titanium nitride plate). Since the entire surface of the titanium plate was changed in color to golden color, it was proved that the titanium nitride layer was generated. Four probes for 150 µm of a resistivity measuring apparatus (manufactured by Kyowa Riken Ltd.) were brought into contact with the formed titanium nitride layer to measure the titanium nitride layer for surface resistance. The average of the resistances at the three points was 0.059 Ω/□. Since no oxide layer was formed on the titanium plate surface but the titanium nitride layer was formed thereon, such a low resistance was obtained.

Next, a direct current power source device was used to energize a plating bath having the following conditions at a current value of 0.99 A for 25 minutes, in which bath platinum to be used as an anode and the titanium nitride plate to be used as a cathode were immersed.

**Table 1**

| [Plating bath conditions] | |
|---|---|
| Potassium auric cyanide (in terms of Au) | 4 g/L |
| Cobalt chloride (in terms of Co) | 2 g/L |
| HCl | 20 ml/L |
| Citric acid | 100 g/L |
| Liquid temperature | 55°C |
| pH | 1 or less |
| Current density | 1 A/dm² |

After the termination of the energization, the titanium nitride plate used as the cathode was measured for the thickness of a gold membrane formed thereon. It was found that the gold membrane formed had an average membrane thickness of 0.829 µm. The voltage at the initiation of the energization was 1.14 V, and the voltage immediately before termination of the energization was 2.75 V.

Next, an adhesive tape was attached to this gold membrane to examine two times at an interval therebetween whether or not the gold membrane peeled off. It was proved that the gold membrane adhered firmly to the titanium nitride plate without peeling off.

### Example 2

In the same way as in Example 1, a titanium nitride plate was yielded. Thereafter, a direct current power source device was used to energize a plating bath having the same conditions as in Example 1 at a current value of 1.00 A for 30 minutes, in which bath the titanium nitride plate to be used as an anode and a bronze plate for use in the Hull cell test method to be used as a cathode were immersed.

After the termination of the energization, the bronze plate used as the cathode was measured for the thickness of a gold membrane formed thereon. It was found that the gold membrane formed had a minimum thickness of 2.76 µm and a maximum thickness of 3.6 µm. The voltage at the initiation of the energization was 2.54 V, and the voltage immediately before the termination of the energization was 2.6 V. The liquid was not turbid and the current was stable.

Next, an adhesive tape was attached to this gold membrane to examine whether or not the gold membrane peeled off at the points where the membrane thickness was 2.76 µm and where 3.6 µm. It was proved that at both the points the gold membrane adhered firmly to the bronze plate without peeling off.

The titanium nitride plate used as the anode was not dirty and did not dissolve, so it was confirmed that the titanium nitride plate fulfilled an electrode function sufficiently.

### Example 3

In the same way as in Example 1, a titanium nitride plate was yielded. Thereafter, a direct current power source device was used to energize a plating bath having the following conditions at a current value of 0.99 A for 30 minutes, in which bath the titanium nitride plates to be used both as an anode and a cathode were immersed.

**Table 2**

| [Plating bath conditions] | |
|---|---|
| Potassium gold cyanide | 6 g/L |
| Sodium dihydrogenphosphate | 15 g/L |
| Dipotassium hydrogenphosphate | 20 g/L |
| Nickel potassium cyanide | 0.5 g/L |
| Liquid temperature | 70°C |
| pH | 6.5 to 7.5 |
| Current density | 0.5 A/dm² |

After the termination of the energization, the titanium nitride plate used as the anode was sound because it was not dirty and did not dissolve. The liquid was not contaminated. The titanium nitride plate used as the cathode was firmly plated with a gold membrane having a thickness of about 2.44 µm. The voltage at the initiation of the energization was 1.9 V, and the voltage immediately before the termination of the energization was 2.45 V.

### Comparative Example 1

Plating treatment was conducted under the same conditions as in Example 2 except that a titanium plate was used as the anode instead of the titanium nitride plate of Example 2.

In order to turn on the current having a current density of 1 A/dm², it was necessary to raise the voltage up to 11-13 V. Thus, power consumption increased sharply. This is because an oxide film was generated on the titanium plate surface and the resistance value thereof was raised.

It was proved that after the termination of the energization for 30 minutes, the titanium plate eluted metal and considerable turbidness was generated in the liquid. In a case where only a titanium plate was used as the anode, the bronze plate of the cathode was able to be electroplated but the plated surface was largely dirty and unpractical.

### Industrial Applicability

As described above, according to the present invention a structure having on its base material surface a titanium nitride layer, can be plated; therefore, in a case of plating titanium with gold, said structure can be directly plated with gold on the basis of the nitriding of titanium while hitherto titanium is plated with gold after being plated with nickel, so that according to the present invention the plating process can be made simple and can be reduced in costs.

A structure having on its base material surface a titanium nitride layer and having electric conductivity, is resistant to corrosion and is a good conductor for electricity; therefore, said structure can be used as a substitute for a platinum electrode. Moreover, according to the present invention an electroplating method can be carried out at a relatively low voltage, and economical effects such as a decrease in electric energy and a large reduction in costs can be achieved.

## Claims

1. A structure that is endowed with electric conductivity by plate-coating with a titanium nitride layer or by generation of a titanium nitride layer on a surface of a base material made of an inorganic material.

2. A structure that is endowed with electric conductivity by plate-coating with a titanium nitride layer or by generation of a titanium nitride layer on a surface of a base material made of an organic material.

3. The structure according to claim 1, wherein said base material is made of a metal having electric conductivity.

4. The structure according to claim 3, wherein said base material is made of titanium or a titanium alloy, and said structure is obtainable by direct nitriding of the base material surface.

5. The structure according to claim 1, wherein said base material is made of a material having no electric conductivity.

6. The structure according to claim 1, wherein thickness of the titanium nitride layer is from 0.01 to 3 µm.

7. A method of electroplating a cathode with a simple metal or an alloy, wherein an anode comprises a structure that is endowed with electric conductivity by plate-coating with a titanium nitride layer or by generation of a titanium nitride layer on a surface of a base material made of an inorganic material or an organic material.

8. A method of electroplating a cathode with a simple metal or an alloy, wherein the cathode comprises a structure that is endowed with electric conductivity by plate-coating with a titanium nitride layer or by generation of a titanium nitride layer on a surface of a base material made of an inorganic material or an organic material.

9. The method according to claim 7, wherein the cathode is plated with a noble metal.

10. The method according to claim 8, wherein the cathode is plated with a noble metal.
